# EUROPEAN PATENT APPLICATION

(11) **EP 0 587 198 A1**
(43) Date of publication of application: **16.03.1994**
(21) Application number: 93117398.3
(22) Date of filing: 16.06.1988
(51) Int. Cl.: B32B 18/00, C04B 35/00, C01G 3/00

(54) **Layered superconducting oxide structure**

(30) Priority: 17.06.1987 JP 150784/87; 24.11.1987 JP 293950/87; 20.01.1988 JP 8473/88; 08.02.1988 JP 25605/88; 03.06.1988 JP 135653/88; 03.06.1988 JP 135654/88
(62) Divisional of application: 88905427.6
(71) Applicant: NIPPON TELEGRAPH AND TELEPHONE CORPORATION, Shinjuku-ku, Tokyo 163-19 (JP)
(72) Inventor: Shuichi, Shibata, Mito-shi, Ibaraki 310 (JP); Takeshi, Kitagawa, Mito-shi, Ibaraki 310 (JP); Hisaaki, Okazaki, Mito-shi, Ibaraki 310 (JP); Takao, Kimura, Ibaraki (JP); Masaharu, Horiguchi, Naka-gun, Ibaraki 311-02 (JP)
(74) Representative: Tiedtke, Harro, Dipl.-Ing.

(57) **Abstract**

Fine and homogeneous oxide particles for superconductors which can be sintered at a low temperature are prepared in a liquid phase by the sol-gel method using alkoxides as starting materials. By forming a buffer layer between a substrate and a superconducting film, good-quality and oriented superconducting film can be fabricated. Highly c-axis-oriented superconducting film and bulk products can be prepared from particular starting compositions in Ln-Ae-Cu-O and Bi-Ae-Cu-O systems. The oriented film can be produced by painting a paste of such starting compositions on a substrate followed by sintering, and the bulk can be produced by pressing the pre-sintered powder of such starting compositions.

## Description

### TECHNICAL FIELD

The present invention relates to a layered superconducting oxide structure.

### BACKGROUND OF THE ART

Recently, superconducting oxide ceramics which shows super-conductivity at or above the liquid nitrogen temperature have been found. For example, YBa₂Cu₃O₇₋ₓ and LnBa₂Cu₃O₇₋ₓ(Ln: a lanthanoid) are reported as superconductors having a superconducting transition temperature (T_{c}) at about 90K. These high-T_{c} superconducting oxides are favorable for wide commercial application, because the price of liquid nitrogen used for a cooling medium is about 1/10 of that of liquid helium. These superconductors are fabricated from oxide powders as starting materials. Since the properties of the superconductors themselves are strongly influenced by the starting materials, not only the fabrication process of superconductors but also the producing method of starting oxide powders are widely investigated.

A solid phase reaction method and a coprecipitation method are known as the techniques for producing oxide powders for superconductors. The fabrication processes in the solid phase reaction method are as follows; the mixture of oxides such as CuO, Y₂O₃ (or Ln₂O₃) and BacO₃ in a certain ratio is sintered at a temperature at 950-1000 °C to make YBa₂Cu₃O₇₋ₓ or YLn₂Cu₃O₇₋ₓ through a solid phase reaction at a high temperature, and then the sintered product is slowly cooled to room temperature and is ground into powder. The fabrication processes in the coprecipitation method are as follows; oxalic acid is added into Cu(NO₃)₂, Ba(NO₃)₃ and Y(NO₃)₃ or Ln(NO₃)₃ water solution to percipitate metallic ions as oxalates, and then the resultant percipitants are dried and calcinated at a temperature of 900-1000°C to decompose the oxalates into oxides, and the products are slowly cooled and ground into powder.

In the solid reaction method, one hundred percent reaction of the components cannot be accomplished, and hence unreacted oxides are often involved in the product. On the other hand, in the coprecipitation method, more homogeneous products can be obtained than that in the solid phase reaction method. It is known, however, that in this technique, the starting composition and the resultant composition of the product are different, which is caused by higher solubility of barium oxalate than those of other components.

In a view point of phase change in crystal, in both of these techniques, non-superconducting phase (tetragonal phase) appears by 900-100 °C sintering at the first stage. Then the tetragonal phase is transformed into superconducting phase (orthorhombic phase) by absorption of oxygen during the subsequent slow cooling process in an oxygen-rich atmosphere. The reason why the sintering temperature higher than 900°C is necessary is that the large particle size of the starting powders made by these techniques shows low activity in the reaction.

Moreover, after the grinding of the calcinated products, the particle size of the powder is in the order of few micrometers and the size distribution is not so sharp. Therefore, to make a dense product from the powder made by these techniques, higher than 1000°C temperature re-sintering is required. Since such a high temperature sintering often generates other crystal phases (not the YBa₂Cu₃O₇₋ₓ or LnBa₂Cu₃O₇₋ₓ phase), sometimes the T_{c} of the sample was lower than the liquid nitrogen temperature.

Meanwhile, for forming a superconducting film, various techniques have been investigated; method using a reaction in gas phase such as a plasma spray coating technique, a vacuum evaporation technique and a sputtering technique, and coating method such as a screen printing technique, a spin coating technique. These techniques involve a heating process after the formation of a film on a substrate, and have some problems. In the vacuum evaporation and the sputtering techniques, the composition of the film is often different from the starting material composition. Furthermore, in the sputtering process, crystal structure and orientation of the resultant film is strongly influenced by the substrate temperature. The screen printing technique also has such a problem that a dense film cannot be obtained easily because of a large particle size of starting powder, and that a critical current density of the film made by this technique is lower than that of a film formed by the sputtering. Another technique for producing superconducting film is proposed; organometallic compounds such as yttrium stearate, barium naphthenate and cupper naphthenate dissolved into a suitable solvent is coated on a substrate and heated to decompose into oxide film. This technique also has a problem that carbon is remained in the film because of the strong reducing atmosphere in the sintering process.

When silicon or silica glass are used for substrates of superconducting oxide film, superconducting phase cannot be obtained because of the reaction between the copper in the oxide film and the substrates during sintering process. Accordingly, low-reactive substrates in sintering such as yttrium-stabilized zirconia (YSZ) or the like are used as a substrate for film forming. Such types substrate, however, have the following problems: (1) since the substrate is an insulator, for a superconducting device involving circuit application, another semiconducting substrate is required; and (2) since it is difficult to make a various shaped substrate such as fiber or tape from ceramics, the shape is limited to a plate-like substrate.

For practical application of the superconducting material, high critical current dendity and high critical magnetic field should be secured. It is known that if the superconducting crystal is c-axis oriented and a current is flowed along a surface perpendicular to the c-axis, critical current density is improved. Therefore, it is desirable that superconducting crystal has a particular orientation. Although, when the YBa₂Cu₃Oₓ powder is pressed into pellet shape, c-axis orientation is observed, no method is reported to realize c-axis orientation effectively.

### DISCLOSURE OF THE INVENTION

An object of the present invention is to provide a process for producing a homogeneous superconducting oxide powder which has a small particle size and can be sintered at a low temperature by solving the above-mentioned problems.

Another object of the present invention is to provide a process for making a high T_{c} superconducting oxide by sintering at a low temperature.

A further object of the present invention is to provide a layered superconducting structure formed on a substrate showing good superconducting properties without any particular limitation of a substrate material.

A still further object of the present invention is to provide a process for forming a superconducting oxide film or bulk products having a high degree of c-axis orientation.

In the first aspect of the present invention, a process for preparing an oxide powder, comprises the steps of:
separately dissolving corresponding raw material alkoxides of a plurality of elements to constitute a superconducting oxide by bonding thereof to oxygen in a solvent;
mixing a plurality of the resulting solutions together;
subjecting the resulting mixed solution to hydrolysis to give a sol; and
evaporating the solvent in the sol.

In the second aspect of the present invention, a process for preparing an oxide powder, comprises the steps of:
separately dissolving corresponding raw material alkoxides of a plurality of elements to constitute a superconducting oxide by bonding thereof to oxygen in a solvent;
mixing the resulting solutions, subjecting the resulting mixed solution to hydrolysis to give a sol, and evaporating the solvent in the sol to prepare a condensed solution;
forming the concentrated solution into a continuous body; and
sintering the continuous body.

Here, the plurality of elements may be yttrium or at least one lanthanoid, at least one alkali earth metal and copper.

A dilute solution of an alkoxide of yttrium or a lanthanoid prepared by an exchange reaction of its chloride with a sodium alkoxide may be used as the raw material of yttrium or lanthanoid. The plurality of elements may be at least one alkali earth metal, bismuth and copper.

At least one operation out of the dissolution and the hydrolysis may be conducted while refluxing the solution or suspension. The solution or suspension after the hydrolysis may be kept at a given temperature to effect the aging thereof.

A powder of the oxide may be mixed with an oxide(s) or carbonate(s) of individual element(s) to constitute a superconducting oxide, followed by forming and baking.

The continuous body may be a bulk. The continuous body may be a film.

The film may be formed on a substrate through a buffer layer. The buffer layer may be a layer comprising zirconia as the main component.

The oxide may have a composition within a range: Ln/(Ln + Ae + Cu) ^{<} 16.6 mol %, Cu/(Ln + Ae + Cu) ^{>} 50 mol % and Ae = the balance (wherein Ln is yttrium or at least one lanthanoid and Ae is at least one alkali earth metal). Further, a powder of the oxide may be pressed to orient the c-axes of its crystals in parallel with the pressing direction.

The oxide may have a composition within a range: Bi/(Bi + Ae + Cu) = 5 - 40 mol %, Ae/(Bi + Ae + Cu) = 15 - 70 mol % and Cu/(Bi + Ae + Cu) = 24 - 64 mol % (wherein Ae is at least one alkali earth metal) . Further, a powder of the oxide may be pressed to orient the c-axes of its crystals in parallel with the pressing direction. The powder may have a composition within a range: Bi/(Bi + Ae + Cu) = 5 - 40 mol %, Ae/(Bi + Ae + Cu) = 15 - 40 mol % and Cu/(Bi + Ae + Cu) = 24 - 64 mol %.

In the third aspect of the present invention, a layered superconducting oxide structure is characterized by comprising:
a substrate;
a buffer layer formed on the substrate and having a low reactivity with the material of the substrate; and
a superconducting oxide film formed on the buffer layer.

Here, the buffer layer may be an oxide film consisting of zirconia or comprising zirconia as the main component.

In the fourth aspect of the present invention, a process for preparing a superconducting oxide, comprises the steps of:
sintering an oxide powder to develop a superconducting phase;
grinding the resulting sinter into a fine powder; and
pressing the fine powder to develop c-axis orientation in a direction parallel with the pressing direction.

Here, the oxide powder may have a composition within a range: Ln/(Ln + Ae + Cu) < 16.6 mol %, Cu/(Ln + Ae + Cu) > 50 mol % and Ae = the balance (wherein Ln is yttrium or at least one lanthanoid and Ae is at least one alkali earth metal).

The oxide powder may have a composition within a range: Bi/(Bi + Ae + Cu) = 5 - 40 mol %, Ae/(Bi + Ae + Cu) = 15 - 70 mol % and Cu/(Bi + Ae + Cu) = 24 - 64 mol % (wherein Ae is at least one alkali earth metal).

The oxide powder may have a composition within a range: Bi/(Bi + Ae + Cu) = 5 - 40 mol %, Ae/(Bi + Ae + Cu) = 15 - 40 mol % and Cu/(Bi + Ae + Cu) = 24 - 64 mol %.

### BRIEF DESCRIPTION OF THE DRAWINGS

Fig. 1 shows an X-ray diffraction pattern of a powder prepared by the sol-gel method in accordance with the present invention;
Fig. 2 shows a change of porosities against treated temperatures of the samples prepared according to the present invention;
Fig. 3 shows relationships between specific surface areas and treated temperature of the powder mixture made by sol-gel method in accordance with the present invention and the commercially available powder mixture;
Figs. 4A, 4B and 4C show X-ray diffraction patterns for samples sintered at 750, 800 and 950°C;
Fig. 5 shows an X-ray diffraction pattern of a zirconia film formed on an Si substrate in the present invention;
Fig. 6 shows an X-ray diffraction pattern of a sintered Y-Ba-Cu-O oxide film formed on a substrate;
Fig. 7 shows resistance vs temperature curve of the film made in accordance with the present invention;
Fig. 8 shows an X-ray diffraction pattern for a c-axis-oriented Y-Ba-Cu-O film formed on a YSZ substrate;
Fig. 9 shows a resistance vs temperature curve for the sample which is shown in Fig. 8;
Fig. 10 shows change in composition after heat treatments;
Fig. 11 shows compositions of the starting Y-Ba-Cu-O compounds made by the sol-gel method in accordance with the present invention;
Fig. 12 shows an X-ray diffraction pattern for the partially oriented sample;
Fig. 13 shows compositions of the starting Y-Ba-Cu-O mixtures of commercially available powder reagents;
Fig. 14 shows an X-ray diffraction pattern for a c-axis-oriented Nd-Ba-Cu-O film sample;
Fig. 15 shows an X-ray diffraction pattern for a c-axis-oriented Y-Nd-Ba-Cu-O film sample;
Fig. 16 shows starting compositions in a Bi-Sr-Ca-Cu-O system;
Fig. 17 shows an X-ray diffraction pattern for an oriented Bi₂(Sr, Ca)₃Cu₂Oₓ film sample in accordance with the present invention;
Fig. 18 shows resistance vs temperature cure for c-axis-oriented Bi-Sr-Ca-Cu-O sample;
Fig. 19 shows an X-ray diffraction pattern for a highly oriented Bi₂(Sr, Ca)₃Cu₂Oₓ film sample;
Fig. 20 shows X-ray diffraction patterns for the powder samples made from the orientation composition and the 1-2-3 composition, respectively;
Fig. 21 is a schematic view illustrating the c-axis orienting by pressing;
Fig. 22 shows relationships between the degree of c-axis orientation peak ratio of (006)/(110)(103)) and the applied pressure;
Fig. 23 shows the compositions from which highly orientation easily obtained by pressing;

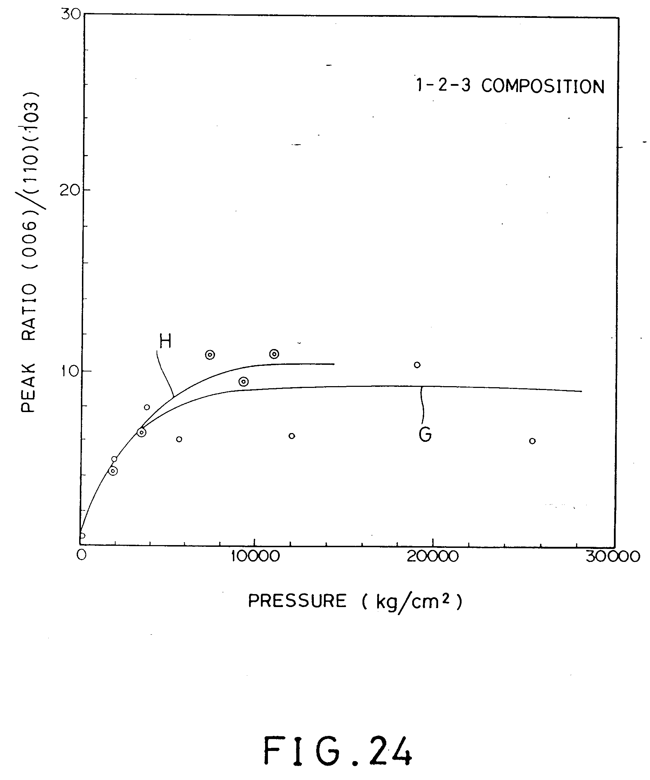

Fig. 24 shows relationships between the orientation (peak ratio of (006)/(110)(103)) and the applied pressure;
Fig. 25 shows an X-ray diffraction pattern for a powder sample prepared from alkoxides;
Fig. 26 shows an X-ray diffraction pattern for c-axis-oriented BiSrCaCu₃Oₓ powder sample;
Fig. 27 shows X-ray diffraction patterns for the samples made by pressing at different pressures; and
Fig. 28 shows relationships between the orientation (presented by peak ratio (008)/2ϑ=27.5°) and the applied pressure.

### BEST MODE FOR CARRYING OUT THE INVENTION

The sol-gel method using alkoxides as starting materials in accordance with the present invention will be presented below.

In the present invention, for preparing superconducting powder, alkoxides are dissolved into solvents and mixed. Then, they are hydrolyzed and dried.

According to the process of the present invention, since raw materials are dissolved into the solvent and hydrolyzed into fine complex oxide particles in a liquid phase, the resultant particles are very small in size and homogeneous. Thus, these powders made by the process in the invention have higher activity for sintering than those made by a conventional processes and are obtained by reaction at lower temperature.

An alkoxides M(OR)ₙ (where M is metal, OR is an alkoxyl group and n is valence state of metal M) is hydrolyzed by water into metallic oxides (or their hydrates) and an alcohol, as shown in the following reaction formula.

M(OR)ₙ + nH₂O → M(OH)ₙ + nROH

mM(OH)ₙ → mMO_{n/2} + mn/2 H₂O

If two or three alkoxides are hydrolyzed simultaneously, fine double or triple complex oxide particles can be formed at a temperature below the boiling point of the solvent.

Generally, the powders prepared by hydrolysis of alkoxides have small size of 0.001 to 0.01 µm. It means that the powder has a large surface energy and shows a good packing ability. Therefore, a dense product can be obtained by sintering at relatively low temperature.

The processes of the present invention will be presented below in detail; (1) preparation of solution, (2) hydrolysis, (3) aging and (4) drying processes.

### (1) Preparation of Solution

Since, in general, alkoxides of copper, barium, yttrium and lanthanoid are all solids at room temperature, solubility of the alkoxides into organic solvents is one of the key point in selection. If the solubility of the alkoxide is very low, an enormous amount of solvent is necessary to hydrolyze and polymerize uniformly, which means it far from the economical application. The solubilities of alkoxide powders into 1 liter of various solvents are determined by the experiments (Table 1).

**Table 1**

| Solubilities of Alkoxide Powders | | |
|---|---|---|
| Alkoxide | Solvent | Solubility (g) in 1 ℓ of Solvent (20°C) |
| Cu(OCH₃)₂ | CH₃OH | 10 |
| Cu(OC₂H₅)₂ | C₂H₅OH | 12 |
| Cu(i-OC₃H₇)₂ | i-C₃H₇OH | 15 |
| Ba(OCH₃)₂ | CH₃OH | 0.04 |
| Ba(OC₂H₅)₂ | C₂H₅OH | 0.07 |
| Ba(i-OC₃H₇)₂ | i-C₃H₇OH | 0.09 |
| Y(OCH₃)₃ | CH₃OH | 0.01 |
| Y(OC₂H₅)₃ | C₂H₅OH | 0.01 |
| Y(i-OC₃H₇)₃ | i-C₃H₇OH | 0.02 |

As shown in Table 1, the solubilities of barium and yttrium alkoxides in 1 liter solvents are several ten mg order; which is one hundredth of that of copper alkoxides. The solubilities of lanthanoids are the same order as those of yttrium alkoxides. These results indicate that it is unpractical to use a dried powder alkoxides of barium, yttrium or lanthanoids as starting materials because of their low solubilities.

Nevertheless, it was found in the experiment that alkoxides can be dissolved in a solvent just after the synthesis. For example, barium alkoxide, which can be obtained by a direct reaction of metallic barium with an alcohol using an reflux technique as shown in the following reaction formula, can be dissolved several tens of grams in 1 liter alcohol solvent before cooling.

Ba + 2ROH → Ba(OR)₂ + H₂

Yttrium or lanthanoid alkoxides which can be synthesized by an exchange reaction of yttrium or lanthanoid chlorides with a sodium alkoxide using reflux technique in an alcohol solvent (given in the following reaction formula), are also dissolved several grams in 1 liter alcohol solvent before cooling.

YCl₃ + 3NaOR → Y(OR)₃ + 3NaCl

LnCl₃ + 3NaOR → Ln(OR)₃ + 3NaCl

Although it is not yet clear about these phenomena, if, after synthesizing, barium, yttrium or lanthanoid alkoxides is used immediately, completely dissolved alkoxides are available for the next reaction. It should be noted that in order to avoid cooling, the alkoxide solutions must be treated immediately after synthesizing. An alcoholic solution containing two equivalents of barium alkoxide is mixed with an solution containing one equivalent of yttrium alkoxide with no cooling. And then, three equivalent of copper alkoxide solution is added with vigorous stirring. Thus starting solution is obtained. For instance, 0.01 mole YBa₂Cu₃0ₓ can be dissolved in 1 liter solvent when isopropanol and isopropoxides are used as solvent and alkoxides, respectively.

It is more desirable that the starting solution involving alkoxides should be refluxed more than 10 minutes. The refluxing make a chance for dispersed alkoxides to meet one another in solution and enables them to make a polynuclear complex or multialkoxides which have similar coordination state as that of the oxides. Oxide powder of multicomponent single phase can be obtained through hydrolysis of polynuclear complexes or multialkoxides.

It is also preferable that reflux in alkoxide synthesizing and mixing is carried out under dry atmosphere not to hydrolyze with moisture in air.

### (2) Hydrolysis.

In hydrolysis, large amount of water is untolerable, because water-soluble hydroxides is formed and from which copper or barium oxides are generated during drying and heating processes.

Deionized water with high purity should be used, because dissociation of copper or barium from the complex compounds is caused by impurities such as chlorine ion in water and hence the change of the compositions is brought. Furthermore, water diluted with the solvent is recommended for uniform hydrolysis reaction.

### (3) Aging

The dried powder, which was obtained from the solution just after hydrolysis, has a small particle size and a high surface activity. Thus, the powder has several problems such that: (1) low crystallinity, (2) primary particles easily aggregate, (3) remarkable adsorption of water on particle surface in air, (4) abnormal grain growth and bubble formation in sintering process. To avoid these problems, powders with 0.01 to 0.1 µm in diameter can be prepared by refluxing or holding a solution at a temperature close to the boiling point of the solvent after hydrolysis. A partially dried or condensed solution after aging is close to gel state, and in it, copper, barium and yttrium exist almostly oxide from with a size of less than 1 µm. These process for preparing the starting materials is named sol-gel method.

### (4) Drying

Available drying methods are; keeping the suspension involved fine particles at a temperature lower than the boiling point of the solvent, or under reduced pressure for evaporating the solvent, and spraying the suspension into small droplet form and dried rapidly in hot air.

The powders, produced as described above, have a size of 1 µm or less and a single phase for superconducting oxides. Thus, they can be sintered at a temperature lower than that of the conventional processes.

The present invention will be described in detail in the following examples.

### Example 1

Metallic barium of 0.02 mole was added to 1 liter isopropanol and refluxed at 83°C for 30 minutes. A colorless transparent barium isopropoxide dissolved into isopropanol was obtained. Yttrium isopropoxide dissolved in 1 liter isopropanol (concentration: 0.01 mole/liter) at 70°C, which was just after preparing by an exchange reaction of yttrium chloride and sodium isopropoxide, was added into the barium isopropoxide solution and refluxed again for 30 minutes. Thereafter, copper isopropoxide powder of 0.03 mole was added to the resultant solution and refluxed again for 1 hour. Into this homogeneous solution, pure water of 0.6 mole was added during refluxing. After the refluxing for 2 hours, the solvent was evaporated at 70°C under reduced pressure, and powder was obtained.

The resultant powder sample was heated at 200°C for 1 hour and specific surface area was measured by BET method. The specific surface area value corresponds to the average particle size of 0.005µm.

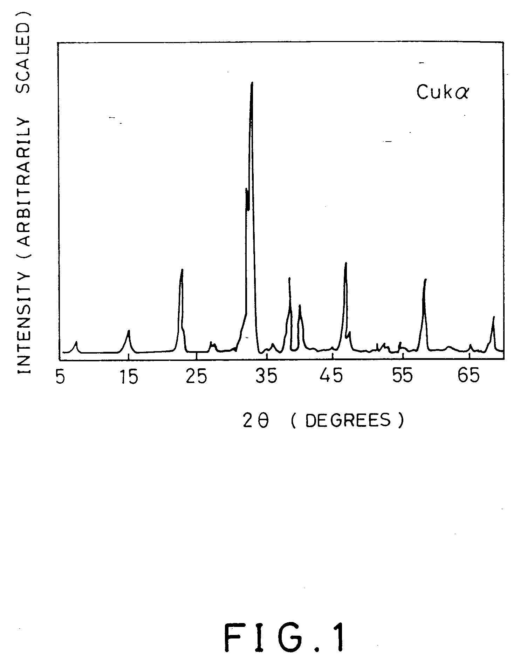

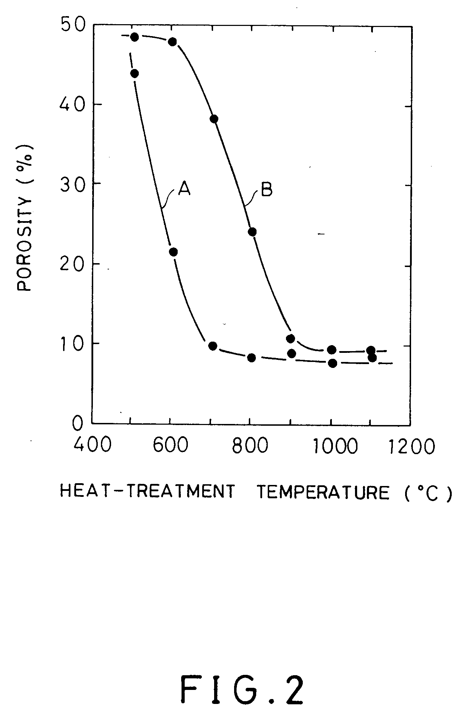

The powder was pressed into pellets and heated at various temperatures for 1 hour in a furnace under oxygen atmosphere, followed by slow cooling to room temperature. In Fig. 1, an X-ray diffraction pattern of the sample heated at 750°C is shown. The sample shows a single phase of YBa₂Cu₃O₇₋ₓ. Porosity change was measured against treated temperature (Curve A in Fig. 2) . At 750°C, the porosity was about 10 % and sintering of the sample was completed. The electrical resistance of the sample heated at 750°C was measured by DC four-probe technique and the temperature of zero resistance was about 90 K.

### Example 2

Powder yttrium barium and copper isopropoxides of 0.01, 0.02 and 0.03 mole, respectively, were added into 1 liter of isopropanol and refluxed with stirring at 83°C for 8 hours. The alkoxides were not perfectly dissolved into the solvent and black percipitates were remained. Water of 0.6 mole was added into the suspension while refluxing and the reflux was continued for 2 hours. Thereafter, the solvent was evaporated at 70°C under reduced pressure and powder sample was obtained.

The crystal phase of the powder was identified by X-ray diffraction pattern as that it was a mixture of CuO, Y₂O₃ and BaCO₃.

The powder was heated at 400°C for 5 hours to evolve solvent and adsorbed water, and then the specific surface area was measured by BET method. The average particle size was calculated from the surface area value as 0.012 µm assuming that spherical particles.

The powder was pressed into pellet and heated in a furnace at various temperature in oxygen atmosphere, followed by slow cooling to room temperature. Crystal phase of the samples were determined by X-ray diffraction method. As a result, it was found that 750°C heating gave an mixed phase of CuO or BaCO₃ and YBa₂Cu₃O₇₋ₓ. On the other hand, 900°C heating gave a single phase of YBa₂Cu₃O₇₋ₓ. Porosity change after heating was measured against treated temperatures (Curve B in Fig. 2). by a mercury injection method. The result indicates that shrinkage began from 600° and finished at 900°C. The porosity after 900°C heating was 11 %. Resistance was measured by a conventional four-probe method. The zero resistance temperature after 900°C heating was about 88 K.

### Example 3

Powder was produced by the similar process described in example 1 except the refluxing time after hydrolysis. After 24 hours refluxing, powder was heated at 200°C for 1 hour and the specific surface area was measured by BET method. The average particle size corresponds to the surface area value was 0.09 µm. Thus, by controlling the reflux time, particles within 0.05 µm to 0.09 µm can be obtained by this technique.

### Example 4

Instead of yttrium isopropoxide, ytterbium or holmium isopropoxides were used and the similar experiment as example 1 was carried out. As a result, LnBa₂Cu₃O₇₋ₓ(ln is Ho or Yb) single phase was obtained by heating at 750°C. Both of the samples showed about 10 % porosities and T_{c} of around 90 K.

As shown in this example, in also the system containing a lanthanoid, powders with a small particle size and a single phase of a superconducting oxide can be obtained. Dense superconducting sintered oxides which shows superconducting state above the boiling temperature of nitrogen can be obtained by a treatment at a relatively low temperature, 750°C.

A very fine powder can be prepared by the sol-gel method in the invention. The powder, however, has some problems such as adsorption of water in air and bubbling in sintering process. These problems of the sol-gel powder can be improved when they were mixed with superconducting oxide crystals of micron or submicron particle size which were prepared by treating a commercially available reagents or commercially available oxide powders at high temperatures.

As commercially available powders, mixture of Y₂O₃, CuO, BaCO₃, etc. mixed at a predetermined ratio, can be used for mixing with the sol-gel powders. And also the powder in superconducting phase which was prepared from commercially available reagents by sintering at 900-950°C in an oxygen atmosphere, followed by slow cooling to room temperature, can be used for mixing with the sol-gel powders.

### Example 5

First of all, the properties of the powder made by the sol-gel technique and a mixture powder of commercially available reagents are compared each other.

A copper ethoxide (Cu(OC₂H₅)₂) powder, barium butoxide (Ba(OC₄H₉₎2⁾ in butanol and yttrium butoxide (Y(OC ₄H₉)₃) in butanol were weighed to make a Y:Ba:Cu=1:2:3: mole ratio and were mixed with 1 butanol as a solvent. The resultant solution was refluxed at about 120°C for 10 hours and distilled water of 5 to 10 times of the total molar amount of Y, Ba and Cu was added. Then, the solution was refluxed for about 10 hours to complete hydrolysis and fine particles were generated in the solution. The solution involving fine particles was kept at about 120°C to evaporate the solvent. Dry sol-gel powder was obtained and stored in a dry box. On the other hand, commercially available reagents of Y₂O₃, BaCO₃ and CuO were weighed to make a 1:2:3 mole ratio and mixed.

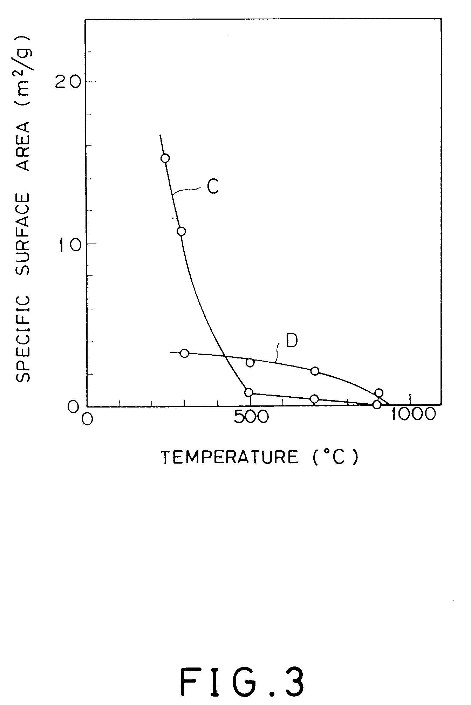

For comparison, the sol-gel powder and the mixture of the commercially available reagents were heated at a temperature from 250 to 900°C and specific surface areas of the samples were measured by BET method (Fig. 3).

In the sol-gel powder (curve C in Fig. 3), a decrease in specific surface area was already observed from around 300°C, which means the start of sintering from this temperature. In contrast, the mixture of commercially available reagents (curve D in Fig. 3) showed the gradual decrease in surface area at above 900°C (means the progress of the sintering). The heat treated samples were examined by X-ray diffraction. In the sol-gel powder, some peaks which can be assained to a superconducting phase were observed in the sample heated at 750°C, while, in commercially available powder mixture, the peaks of superconducting phase were observed in the sample heated at or higher than 900°C.

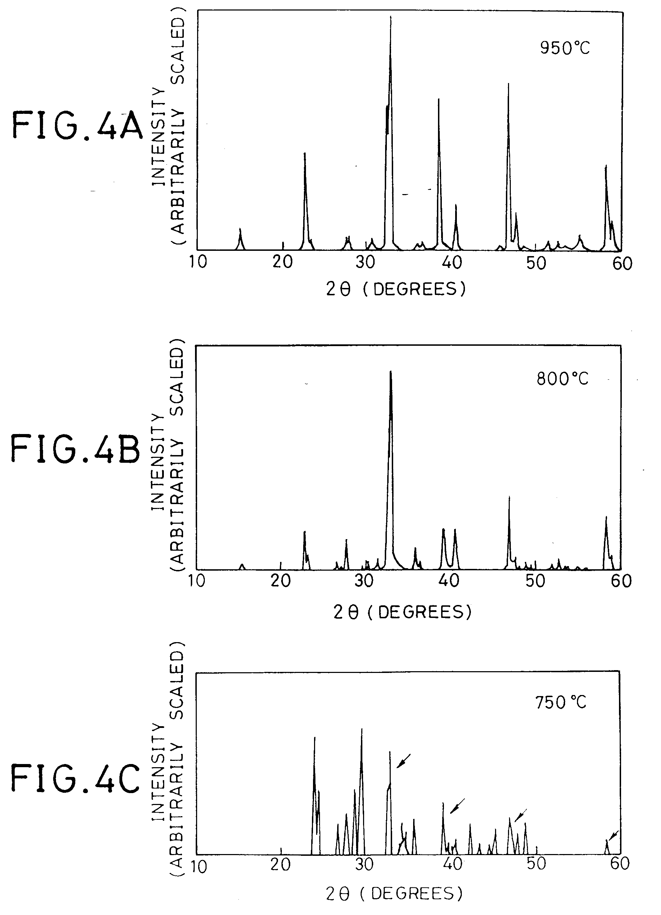

The commercially available powder mixture was sintered at 950°C in an oxygen atmosphere and slowly cooled (hereinafter called as "commercially available sintered powder") . The sol-gel powder was mixed with the commercially available sintered powder in a weight ratio of 1:1. The resultant mixture powder was sintered at various temperatures of 400, 500, 750, 800 and 950°C and their X-ray diffraction patterns were measured. The results in X-ray diffraction patterns of the samples heated at 750, 800 and 950°C are shown in Figs. 4A, 4B and 4C.

Peaks which can be assigned to the superconducting phase (shown by arrow in the diffraction pattern of the powder sintered at 750°C) (other peaks are assigned to BaCO₃) appeared in the samples heated at or higher more than 750°C. In the 800°C sample, a single phase of YBa₂Cu₃O₇₋ₓ was observed, the diffraction pattern was almost the same in 950°C sample. Thus, it can be said that the superconducting phase appeared from 800°C.

The above results indicate that the technique of mixing the sol-gel powder with the commercially available powder can improve the above-mentioned problem such as adsorption of water and so on, and also showed that the superconducting phase can appear at a temperature lower than that of the conventional technique.

Powders prepared by mixing the sol-gel powder with the commercially available sintered powders at the ratios of 1:1, 1:05. and 0.5:1 were pressed into pellets and sintered. The electrical resistance vs temperature curves of these samples were measured by a conventional four-probe technique. They showed zero resistance temperatures at about 80 to 90 K.

A method for preventing a reaction of a superconducting oxide film and a substrate in sintering process will be described below; A buffer layer is formed on a substrate, and superconducting oxide film is formed on it.

It is preferable to use a zirconia for the buffer layer, because it has a low reactivity at high temperature. Zirconia, which has the transition point at about 1100°C, shows a large volume change when it is transformed from a tetragonal (high-temperature form) to rhombic phase (low-temperature form). Thus, a heating higher than the phase transition point often cause a breakage of a film during the course of temperature rise and fall. Therefore, it is more preferable to use zirconia containing yttrium, calcium etc. of 20 % or less, because addition of these elements is useful to stabilize a cubic phase to low temperature region and suppress the tetragonal-rhombic phase transition. In order to prevent a reaction of superconducting film and a substrate, more than 0.1 µm thickness of zirconia buffer is necessary. A method for forming a zirconia buffer layer will be described in detail below.

Procedures for forming a zirconia film are; (1) washing a substrate, (2) preparing a sol, (3) coating, (4) drying and (5) sintering.

### (1) Washing a Substrate

Substrates such as silicon, SiO₂ glasses, alumina etc. are washed with an acid, pure water, an organic solvent, and dried. Acids, for example, nitric acid and hydrofluoric acid can be used for removing foreign matters from a substrate surface. Sufficient drying of a substrate is required, because water or something like that on the surface prevent the formation of homogeneous buffer film.

### (2) Preparing a Sol

Desirable conditions for preparing a sol depend on the main starting materials of the film. Cases where zirconia alkoxides and organometallic acids are used respectively are described. Zirconium alkoxides: the zirconium alkoxide is diluted with a solvent containing hydrolysis-suppresser. Often compounds of the elements for stabilizing a cubic phase of zirconia, such as yttrium or calcium are added in a solvent. Zirconium propoxide and butoxide are recommended since they are mildly hydrolyzed (when compared with methoxide or ethoxide). The hydrolysis-suppressor is used to suppress the rate of hydrolysis of high-active alkoxides and to make a homogeneous sol. The suppressors include carboxylic acid such as acetic acid, and polyhydric alcohols such as ethyleneglycol, and acetylacetone and so on. More than 0.01 mole suppressor are needed for 1 more alkoxide. As the solvent, organic materials which have boiling points of 200°C or below are preferable, because they can be evaporated easily. The ratio of the solvent is more than 1 mole and less than 1000 mole for 1 mole alkoxide. Alkoxides are also preferable for the starting reagents of yttrium and calcium. Addition of water containing an acid catalyst such as diluted hydrochloric acid into the sol is useful to keep the properties of the sol for a long period of time because the addition moderates a polycondensation reaction. Organometallic acid: for example, when zirconium acetate is used, hydrolysis-suppresser or even water is not necessary. The other conditions are the same in the case of zirconium alkoxide.

### (3) Coating

Sol is uniformly coated on a clean substrate. Adequate coating methods include the dipping method, spin-coating method, spray coating and die coating. The thickness of the film can be controlled by choosing the concentration of raw materials, speed of pulling up in the dipping technique, rotation speed in the spin-coating technique, spray rate in the spray coating technique and pulling speed in the die coating technique. Since formation of a thick film by one-step coating results in cracking in the film during drying process, the thickness of the film by one-step coating must be restricted within 0.5 µm.

### (4) Drying

The sol films on substrates are put in an air. Then, hydrolysis and evaporation of the solvent proceed and dry films can be obtained. Drying should be done in an atmosphere where the humidity and vapor pressure is controlled to be constant.

### (5) Sintering

A ZrO₂ film on a substrate can be obtained by sintering at a temperature of 500°C or higher. The sintering atmosphere desirably contains an oxygen.

The film fabricated in the above-mentioned manner is a dense and homogeneous film with fine rhombic or cubic zirconia phase, of 0.01 to 0.5 µm in thickness. A thick zirconia film can be produced by repeating the sol coating and drying followed sintering or repeating all procedures from sol coating to sintering.

Various methods can be applied to form a superconducting oxide film on the buffer layer. The liquid-phase technique gave an oriented superconducting film on a zirconia-coated substrate. Particularly, a homogeneous solution with high concentration can be prepared by dissolving alkoxide starting materials in a polyhydric alcohol solvent or a mixed solvent of a polyhydric alcohol and acetic acid. The coating film made from this solution by dipping, spin coating, spray coating technique,followed by drying and sintering processes, is characterized by excellent smooth surface.

### Example 6

A silicon wafer with a polished surface was washed with hydrofluoric acid and used as a substrate. A zirconium alkoxide, Zr(n-OC₄H₉)₄, was diluted with isopropanol and mixed with a small amount of acetic acid (starting sol) . The substrate was dipped into the starting sol and pulled up at a certain rate. The sol coating on the substrate was hydrolyzed and dried in an air. The sol coated substrate was sintered in an electrical furnace at 500°C in an oxygen atmosphere. The procedures from dipping to sintering was repeated several times and zirconia-coated Si substrate was prepared. Meanwhile, 0.03 mole Cu(n-OC₄H₉)₂_{,} 0.02 mole Ba(n-OC₄H₉)₂ and 0.01 mole Y(n-OC₄H₉)₃ dissolved in n-butanol was hydrolyzed, and the solvent was evaporated. Obtained sol-gel Y-Ba-Cu-O powder was mixed with ethyleneglycol to make a paste, and printed on a zirconia-coated Si substrate by screen-printing technique. After drying, the film was sintered at 900°C.

The zirconia film was examined by X-ray diffraction and scanning electron microscope (SEM). The thickness of the film was measured by the contact method. The sintered Y-Ba-Cu-O coating film was examined by X-ray diffraction, and the resistance of the film was measured by DC four-probe technique.

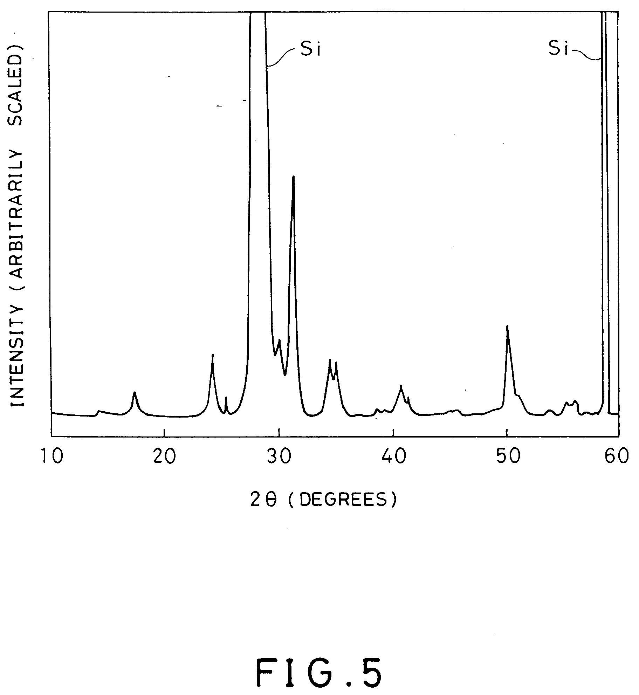

X-ray diffraction pattern of the zirconia film on Si substrate is shown in Fig. 5. Since the intensities of the diffraction peaks are low and their half width values are large, zirconia coat seems to be microcrystals. High homogeneity was achieved in the zirconia film, and the surface of the zirconia film was so smooth which was observed by SEM.

In this experiment, one dipping gave a zirconia film of 0.05 µm in thickness. A 2.5 µm thick film was obtained by 50 time repeating.

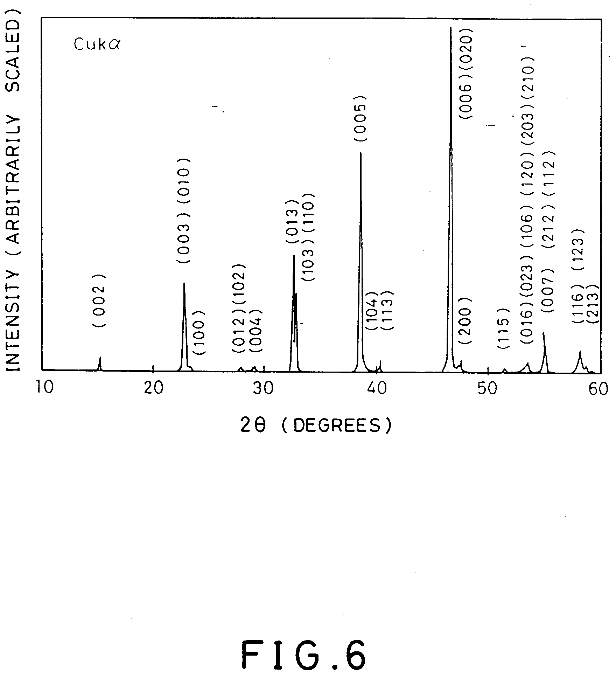

The X-ray diffraction pattern of the Y-ba-Cu-O sintered film on a zirconia film of 2.1 µm in thickness is shown in Fig. 6. The film was a single phase of YBa₂Cu₃O₇₋ₓ. Since (002), (003), (005) and (006) peaks are strong, it can be said that the film is c-axis-oriented perpendicular to the substrate surface.

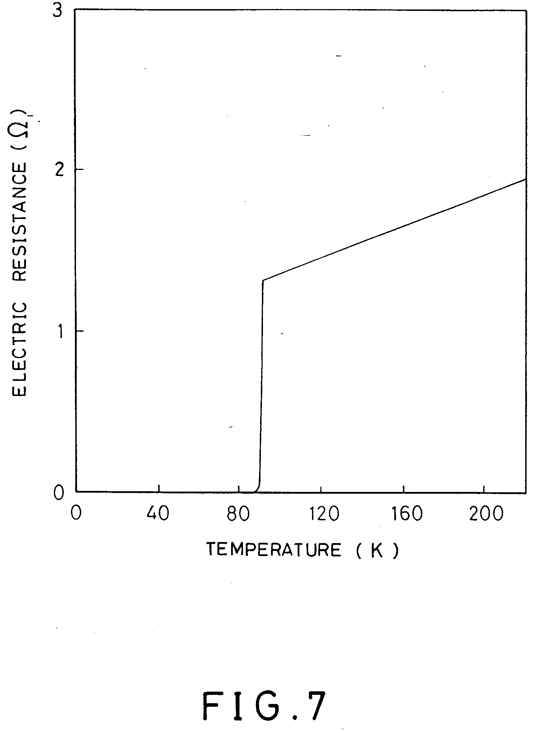

In Fig. 7, electrical resistance vs temperature curve for the superconducting film is shown. The onset temperature and the zero resistance temperature were 91 K and 86 K, respectively. The transition width was 5 K. This good results are attributed to complete connection in a-b planes, which function as superconducting path, in the film due to the c-axis orientation and a high density of the film.

### Example 7

A pure silica glass plate after washing with a hydrofluoric acid was used for a substrate. Zr(n-OC₄H₉)₄ of 0.9 mole and Y(n-OC₄H₉)₃ of 0.1 mole was mixed in isopropanol solvent and small amount of acetic acid was added in it to make a starting sol. The sol film was fabricated by spin coating technique and hydrolyzed, dried in an air. The film was sintered in the same manner in example 5 and the procedures from coating to sintering were repeated 50 times. Cu(OC₂H₅)₂ of 0.03 mole, Ba(n-OC₄H₉)₂ of 0.02 mole and Y(n-OC₄H₉)₃ of 0.01 mole were diluted with ethyleneglycol containing acetic acid and a transparent solution was prepared. The film made by spin coating technique was dried and sintered at 900°C. The Y-Ba-Cu-O superconducting film was obtained on the Y-stabilized zirconia buffer layer. The procedures from spin coating to sintering was repeated 50 times.

The yttrium-added zirconia film was confirmed as a dense and homogeneous film by SEM observation, and it is composed of cubic zirconia which was determined by X-ray diffraction pattern. The cubic zirconia was stabilized by addition of yttrium down to room temperature. The film had a thickness of 1.6 µm.

The Y-Ba-Cu-O film had 1.0 µm thickness and a smooth surface. The film was c-axis-oriented YBa₂Cu₃O₇₋ₓ which was determined by the X-ray diffraction pattern. The film showed the onset temperature of 90 K and zero resistance temperature of 85 K.

### Example 8

A silicon wafer with polished surface was used for a substrate. A solution of Zr(n-OC₄H₉)₄ which was prepared in the same manner as in example 6 was sprayed on the substrate heated at 400°C, and the solvent dried rapidly. The procedures from spraying to drying were repeated 20 times. The zirconia film was obtained by sintering the film at 900°C.

A solution of the Y-Ba-Cu system which was prepared in the same manner as in the example 7 was then sprayed on the zirconia-coated substrate heated at 400°C, and dried. Then, Y-Ba-Cu-O superconducting film was prepared by sintering at 900°C.

The zirconia film and the sintered Y-Ba-Cu-O film were examined by X-ray diffraction and scanning electron microscope (SEM) and the thickness of the films were measured by the contact method. The resistance of the Y-Ba-Cu-O film was measured by DC four-probe technique.

The zirconia film made by the above-mentioned process was rhombic phase and with a thickness of 1.5 µm. The sintered Y-Ba-Cu-O film was composed of an oriented (YBa₂Cu₃)₇₋ₓ crystal and with a thickness of 0.9±0.2 µm. The film showed the onset temperature of 90 K and the zero resistance temperature of 84 K.

### Example 9

A silica glass optical fiber was drawn from the preform in a carbon resistance furnace and immediately coated with the starting sol of zirconia (prepared in the same manner in the example 6) using die coating technique. The coated fiber was sintered at 500°C in the furnace installed just under the drawing furnace. Subsequently, the resultant zirconia-coated fiber was coated with a Y-Ba-Cu alkoxide mixed solution by die coating technique, followed by sintering at 900°C to make an oxide-coated optical fiber.

The oxide coating layer was removed and identified as the YBa₂Cu₃O₇₋ₓ phase by powder X-ray diffraction method.

As shown in this example, a superconducting oxide-coated optical fiber can be produced by the present invention, which suggest a possibility of power supply to an optical communication system using a superconducting line. Although, in above-mentioned examples, the sol solution which was made from zirconium alkoxide by hydrolysis was used for forming a buffer layer, a buffer layer can also be produced by the pyrolysis technique using an organic acid salt, or a chemical or physical vapor deposition method and so on. Moreover, although, in the examples, silicon wafer, silica glass plate and optical fiber were used for the substrates, the present invention can be applied to various shaped and material's substrates, for example, such as a cylinder or a tape-shaped substrate and alumina or InP or other materials.

A method for fabricating a c-axis-oriented superconducting film will be described below.

In making an Ln-Ae-Cu-O (Ln: yttrium or a lanthanoid, Ae: at least one alkali earth metal) or Bi-Ae-Cu-O superconducting oxide, the use of the starting materials within a particular composition region can enhance the degree of c-axis orientation.

### Example 10

A copper alkoxide, Cu(OC₂H₅)₂, a barium alkoxide, Ba(OC₄H₉)₂, and an yttrium alkoxide, Y(OC₄H₉)₃ were mixed together in such a ratio as will provide an oxide composition of 66 mole % Cu, 27 mole % Ba and 7 mole % Y, and added into n-butanol solvent. The resultant mixed solution was refluxed for 20 hours and pure water of 5 to 10 times of total Cu, Ba and Y was titrated into the solution with ultrasonic vibration. The solution was refluxed again for 10 hours to complete a hydrolysis reaction. Then, the homogeneous solution was partially dried to increase the viscosity to make an appropriate paste for painting onto a substrate. A part of the solution was dried perfectly and subjected to a composition analysis.

The paste was painted on a yttrium-stabilized zirconia (YSZ) substrate and heated at 950°C for 30 minutes. Then, the sample was slowly cooled to 600°C at a rate of 1°C/min, kept at 600°C for 10 hours, and slowly cooled again to room temperature under oxygen gas flow condition.

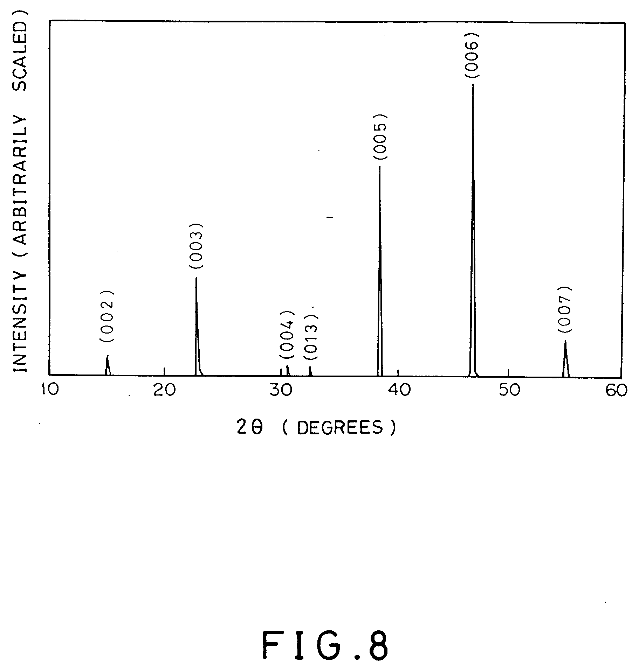

The X-ray diffraction pattern of the resultant film on YSZ is shown in Fig. 8. Since peaks of (002), (003), (004), (005), (006) and (007) are very strong, it can be said that the film was c-axis-oriented perpendicular to the substrate.

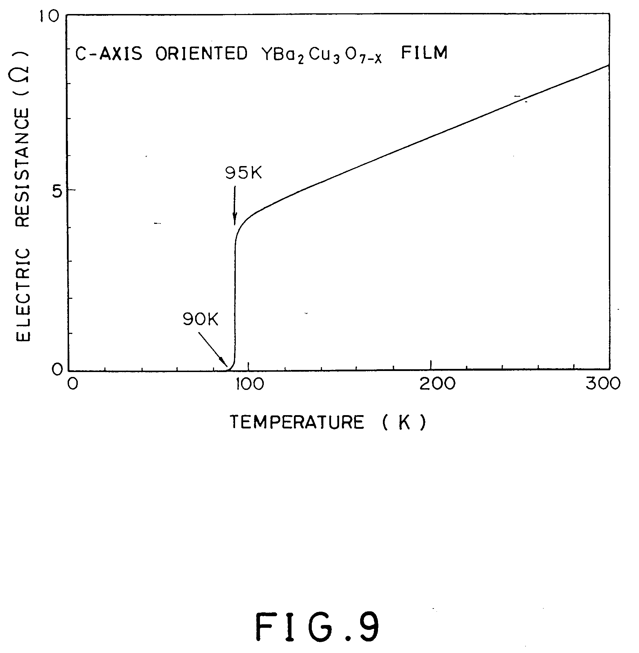

Fig. 9 shows electrcial resistance of the film was measured by a conventional four-probe technique. The onset temperature was 95 K and the zero resistance temperature was 90 K. The results are comparable to the T_{c} value of bulk samples.

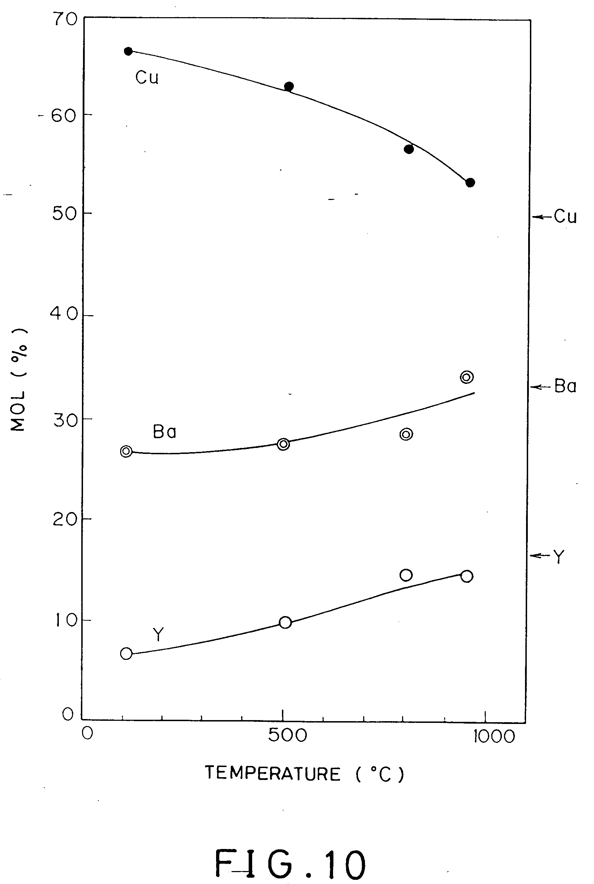

The compositions of the film were determined by an X-ray fluorescence analysis. The change of the composition of the film by heating is shown in Fig. 10, wherein the abscissa represents the treatment temperature while ordinate represents mole percentage.

The arrows at the right end of the figure shows the mole percentages of a superconducting phase of YBa₂Cu₃O₇₋ₓ (Y: 16.7 mole %, Ba: 33.3 mole %, Cu: 50.05 mole %).

Although the starting composition of the compound was chosen to be located in a Cu-rich and Y-poor side, the Cu content decreased remarkably during the heat treatment when the temperature is increased. Therefore, consequently, Ba and Y contents increased relatively and approached to a 1-2-3 composition which indicated by the arrows. As a result, it was found that the composition deviation of the starting compound toward the Cu-rich side from the 1-2-3 composition is naturally corrected by heating, and the Cu-rich starting composition can make a strong c-axis-oriented film on a ceramic substrate. The reason why the c-axis orientation can be achieved from the Cu-rich starting composition has not yet clear. However, the melting points of CuO, BaO and Y₂O₃ are known to be 1232°C, 1923°C and 2440°C, respectively. Therefore, it can be expected that the element which shows lowest melting point, CuO, first react at a low temperature and then the rearrangement of atoms results in the orientation.

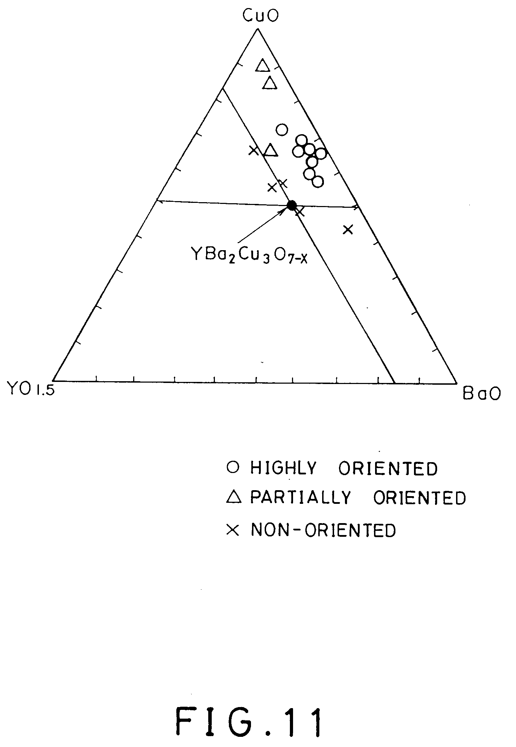

Compositions of the starting Y-Ba-Cu-O compounds (made from alkoxides) are plotted in a ternary system graph in Fig. 11. Sintering was carried out at 950°C for 30 minutes.

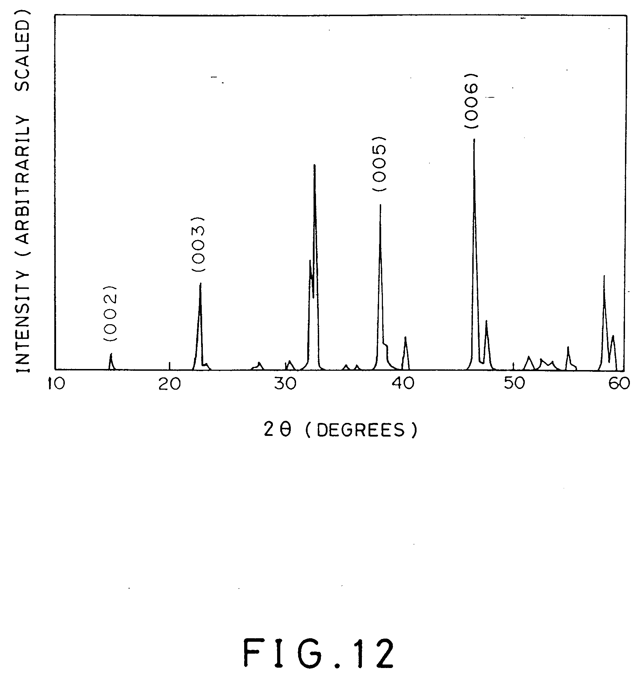

Circles in this figure shows a highly oriented sample as shown in the X-ray diffraction pattern in Fig. 8. Triangles shows a partially oriented samples, of which X-ray duffraction pattern is shown in Fig. 12. The corsses stand for non-oriented sample. The 1-2-3 starting composition which is shown as closed circle in Fig. 11 gave non-oriented sample. It can be confirmed from Fig. 11 that the suitable starting compositions for the orientation are less than 16.6 mole % Y and more than 50 mole % Cu.

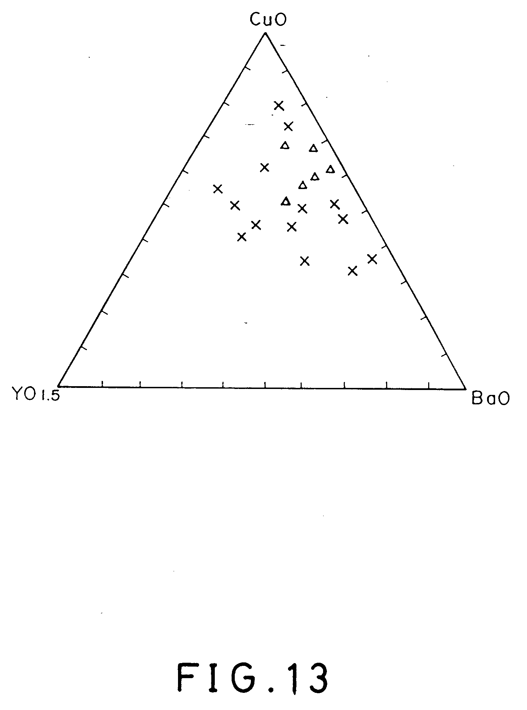

The above-mentioned phenomenon is expected to be notable when a film is formed from fine oxide particles less than submicron order, such particles made by the sol-gel method as in this example. The smaller the particle size, the higher the activity of the particles, and hence the lower the temperature at which migration of atoms becomes possible. In order to demonstrate this hypothesis through an experiment, the same orientation experiments by heating was carried out using commercially available reagents such as Y₂O₃, BaCO₃ and CuO of large particle sizes (1 to several µm) as starting materials. Since a higher temperature is necessary for achieving an orientation in such reagents of large particles, the temperature was set at 1000°C for 30 minutes. In the preliminary experiments using commercially available reagents, it was confirmed that no clear orientation can be observed when the heating is lower than 1000°C, and when higher than 1000°C, reaction of a superconducting oxide film with a substrate is so severe that the superconductor is damaged. In Fig. 13, the starting compositions in commercially available reagents are shown with the degree of the c-axis orientation. Triangles and crosses show the partially oriented and non-oriented samples.

The region which shows the orientation is slightly narrower than that in Fig. 11 (in the case of sol-gel powder) and the degree of the orientation is lower. Consequently, fine particles prepared by the sol-gel method are more suitable than the commercially available reagents in terms of the orientation.

### Example 11

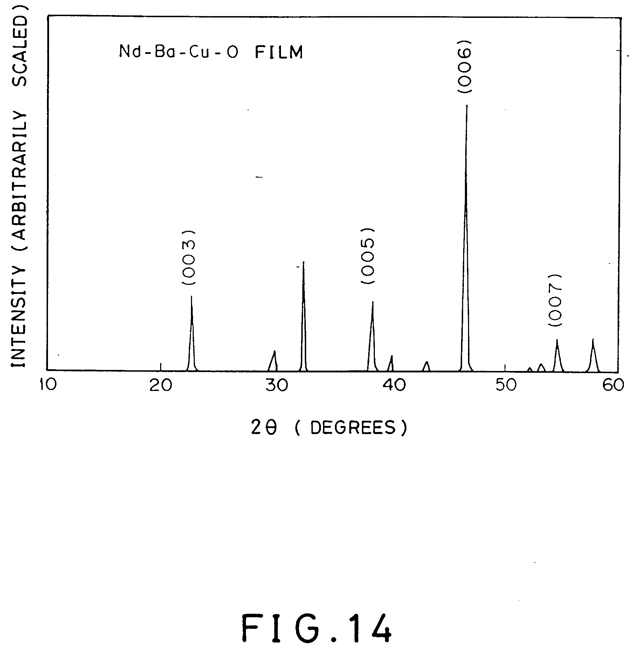

A copper alkoxide, Cu(OC₂H₅)₂, a barium alkoxide, Ba(OC₄H₉)₂, and neodymium alkoxide, Nd(OC₄H₉)₃ were mixed together in such a ratio as will give a Cu-rich and Nd-poor composition oxide (Cu: 60.2 mole %, Ba: 30.8 mole %, Nd: 9.0 mole %) and added into n-butanol as a solvent. The same procedures of reflux and hydrolysis as in the example 10 were carried out. The resultant solution was condensed to have suitable viscosities for screen printing or spray coating techniques. The films were formed on YSZ substrates by these techniques. The film on a YSZ substrate was heated at 950°C for 30 minutes in an oxygen gas flow condition, and then slowly cooled to room temperature. The X-ray diffraction pattern for thus obtained Nd-Ba-Cu-O film is shown in Fig. 14.

Although no peaks assigned to (002) and (004) were observed, the other peaks corresponding to (00N) (N=3, 5, 6, 7) appeared with high intensities. Thus, it was also confirmed in a Nd-Ba-Cu-O system that the c-axis orientation can be performed when a starting compound with a Cu-rich and Nd-poor composition is used.

### Example 12

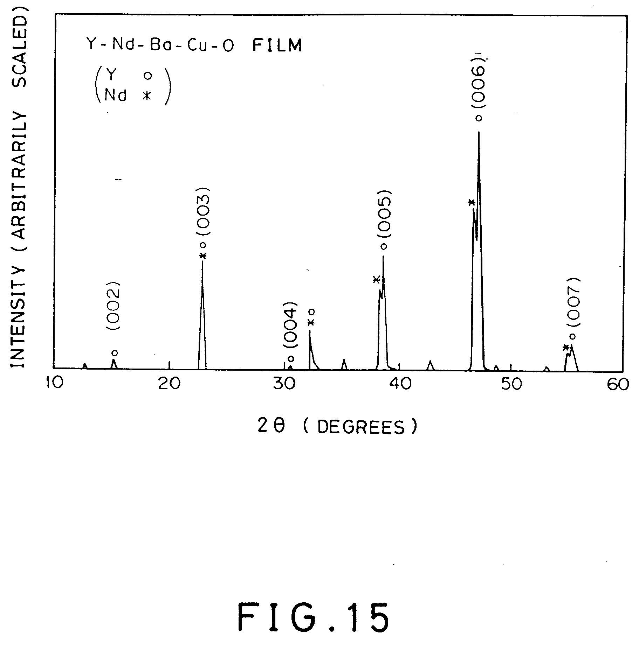

A Y-Nd-Ba-Cu-O superconducting film was produced from alkoxides as starting materials on a YSZ substrate in the similar manner to examples 10 and 11. The starting composition was 7.8 mole % Y, 5.3 mole % Nd, 17.9 mole % Ba and 69 mole % Cu; Cu-rich and Y, Nd-poor composition. The X-ray diffraction pattern for the Y-Nd-Ba-Cu-O superconducting film sample is shown in Fig. 15.

Peaks peculiar to the c-axis orientation were observed. Furthermore, since the ionic radii of Y and Nd are different from each other (Y: 1.06 Å and Nd: 1.15 Å), the lattice constants are also different (lattice constant: Y<Nd, 2ϑ: Y>Nd), and the peaks corresponding to (005), (006) and (007) for Y and Nd appeared separately. In the figure, circles and stars stand for the peaks for Y and Nd, respectively.

Consequently, it is found that the film in an Ln-Ba-Cu-O (Ln: lanthanoid) system and a mixed system can also be c-axis-oriented when the suitable starting composition is chosen.

Although the shape of the substrate in the examples are plate-like, the present invention can also be applied various shaped substrates. For example, since the ceramics such as YSZ is known to show superplasticity, fiber or other shapes can be produced.

### Example 13

A Y-Ba-Cu-O powder was prepared by the sol-gel method and mixed with ethylene glycol to make a paste. The paste was painted on an Al₂O₃ substrate and heated at 900-950°C for 10-30 minutes to make a superconducting film. Since an Al₂O₃ substrate generally tends to show a slightly higher reactivity with a superconducting material at high temperature than a YSZ substrate, the heating temperature for films on Al₂O₃ substrates must be a little lower than that for YSZ substrates. Nevertheless, a c-axis-oriented film was obtained from a Cu-rich and Y-poor starting composition as shown in examples 10 to 12. Therefore, it can be said that basically there is no limitation about the selection rule of substrate to form a oriented superconducting oxide on it.

The reactivities of substrates with a superconducting material at a high temperature, of course, depend on the material of the substrate. Through the experiments, however, it was confirmed by the inventors that it is also possible to form a c-axis-oriented film on a buffer layer such as CuO, Y₂O₃, ZrO₂ etc., which can be prepared by, for example, using the sol-gel method.

A c-axis-oriented superconducting oxide film in Bi-Ae-cu-O system (where Ae is at least one alkali earth metal) can also be made in the same manner as described above.

### Example 14

Commercially available reagents of Bi₂O₃, SrCO₃ CaCO₃ and CuO with average particle size of 1 µm or more was mixed and added into ethylene grycol and mixed again sufficiently to make a paste for painting. The paste was painted on a YSZ or an Al₂O₃ substrate by screen printing using a 300 mesh screen. After enough drying, the film on a sbustrate was sintered at 900°C. The Bi-Sr-Ca-Cu-O film of 10 µm in thickness was obtained.

Crystal structure and the degree of orientation of the films were measured by X-ray diffraction. Electrical resistances of the films were measured by DC four-probe technique.

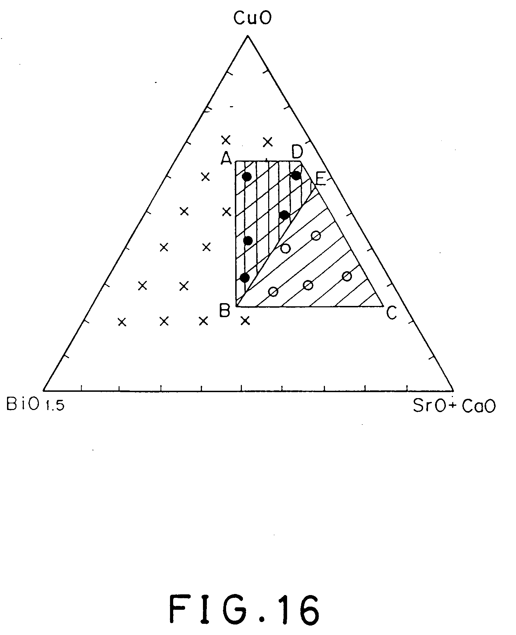

Starting compositions in Bi-(Sr, Ca)-Cu-O system (SrO/(CaO+SrO)=0.5) are shown in Fig. 16. Closed and open circles shows the samples of superconducting phase, and crosses show non-superconducting samples. The closed circles stand for the c-axis-oriented superconducting samples. Thus, in Fig. 16, the area surrounded by A-B-C-D lines (Bi/(Cu+Sr+Ca+Bi)= 4-40 mole %, (Sr+Ca)/(Cu+Sr+Ca+Bi) = 15 to 70 mole %, Cu/(Cu+Sr+Ca+Bi)=24-64 mole %) is the region where a superconducting phase of Bi₂(Sr, Ca)₃Cu₂Oₓ appeared. Particularly, the region surrounded by A-B-E-D lines (Bi/(Cu+Sr+Ca+Bi)= 5-40 mole %, (Sr+Ca)/(Cu+Sr+Ca+Bi) = 15 to 40 mole %, Cu/(Cu+Sr+Ca+Bi)= 24-64 mole %) shows the area where c-axis-oriented film samples were obtained. When the ratio of SrO/(CaO+SrO)=0.25-0.75, c-axis-oriented samples were also obtained.

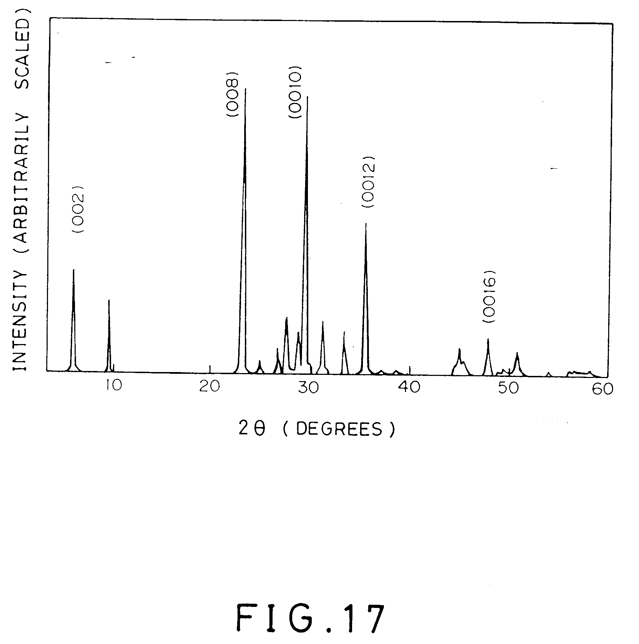

The X-ray diffraction pattern of the film made from the starting composition in the region surrounded by A-B-E-D lines is shown in Fig. 17. Strong diffraction peaks which are assigned to (00N) of Bi₂(Sr, Ca)₃Cu₂Oₓ (c-axis length: 30.6 Å) are observed in this pattern, which indicates the c-axis orientation perpendicular to the substrate.

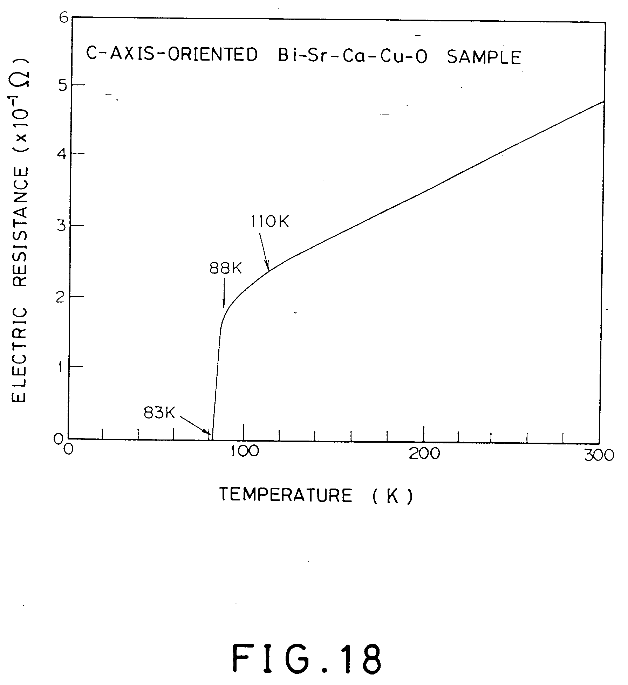

Electrical resistance vs temperature curve for the oriented sample is shown in Fig. 18. The film showed a sharp transition with the onset temperature of 88 K and the zero resistance temperature of 83 K.

Although the reason why the c-axis orientation occurs in the composition region surrounded by A-B-E-D lines in Fig. 16 is not yet clear, it can be presumed that the partial melting is also attributed to the orientation, because the region is located in Cu and Bi-rich side (elements has low melting points in the system).

### Example 15

Alkoxides were used as the starting materials to make a superconducting film as in the example 14. Bi(OC₄H₉)₃, Sr(OC₄H₉)₂, Ca(OC₃H₇)₂ and Cu(OC₃H₇)₂, in respective n-butanol solution were mixed and hydrolyzed, followed by refluxing for 10 hours to form fine oxide particles. The solvent was evaporated to make a paste. The paste was screen-printed on a YSZ substrate and after drying was sintered at 850°C. The Bi-Sr-Ca-Cu-O superconducting oxide film was obtained.

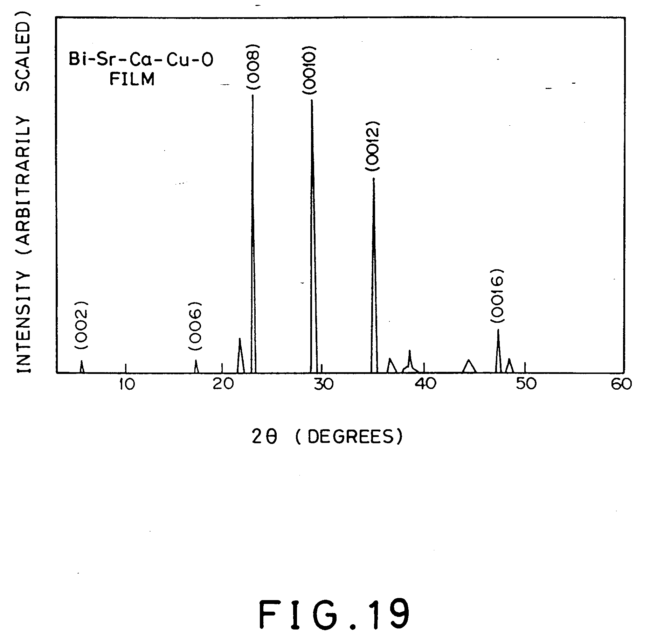

In using alkoxides as starting materials, the superconducting phase of Bi₂(Sr, Ca)₃Cu₂Oₓ also appeared in the composition region surrounded by A-B-C-D lines and the c-axis orientation was also observed in the sample whose composition belong to the region surrounded A-B-E-D lines in Fig. 16. The X-ray diffraction pattern for the oriented film whose starting composition is within the region surrounded by A-B-E-D lines is shown in Fig. 19. The degree of the orientation of the film is higher than that of the sample in Fig. 17, that is, of the sample prepared by using commercially available reagents. The oneset temperature and the zero resistance temperature were 88 K and 87 K, respectively. The transition from normal to superconducting phase was very sharp.

Thus, using alkoxide as the starting materials high quality film with high degree of orientation can be produced as compared with using commercially available reagents.

### Example 16

A superconducting film in Bi-based system was formed on a zirconia-coated silicon substrate.

A silicon wafer with a polished surface was used for the substrate. A starting sol for zirconia coating was prepared from a zirconium alkoxide, Zr(n-OC₄H₉)₄ diluted with isopropanol. A small amount of acetic acid was also added in the starting sol. The silicon wafer was dipped into the sol and pulled up at a constant rate. The coated substrate was dried in an air and sintered at 900°C in an oxygen atmosphere. The procedures from dipping to sintering were repeated 50 times to obtain a zirconia-coated silicon substrate. A Bi-Sr-Ca-Cu-O paste, in the composition region A-B-E-D, prepared by the alkoxide hydrolysis was screen-printed on the zirconia-coated silicon substrate and sintered at 875 °C in oxygen atmosphere.

The crystal structures of the zirconia-coated substrate and the sintered Bi-Sr-Ca-Cu-O film were identified by X-ray diffraction and the resistance vs temperature curve of the oxide film was measured by DC four-probe technique.

The surface of the zirconia coating was very smooth by optical observation and the film had a high homogeneity. The film thickness measured by X-ray diffraction was 2.5 µm.

The X-ray diffraction pattern of the sintered Bi-Sr-Ca-Cu-O film showed a formation of c-axis-oriented Bi₂(Sr, Ca)₃Cu₂Oₓ phase. The onset and zero resistance temperatures of the film were 88 K and 80 K with a transition temperature width of 8 K.

Although screen printing technique was used in the example, various techniques such as spray coating etc. can be applied to make a superconducting film. And in the example, zirconia-coated silicon was used for the substrate, the materials of the substrates and buffer layer is not limited in so far as they can have a low reactivity with a superconducting oxide in sintering process.

Processes for preparing a c-axis-oriented bulk sample will be described below. By using a pressing technique of superconducting oxides, a bulk sample which is c-axis-oriented parallel to the pressing direction can be produced.

### Example 17

Reagents Y₂O₃, BaCO₃ and CuO were mixed to make two types of compounds with different compositions; one is Y:Ba:Cu=1:2:3 (called as 1-2-3 composition) (Y=16.7 mole %, Ba=33.3 mole % and Cu=50.0 mole %) and the other is a composition of Y=8 mole %, Ba=30 mole %, Cu=62 mole % (called as orientation composition). The mixtures were pre-sintered at 950°C for 5 hours in an oxygen atmosphere and ground to make powder samples.

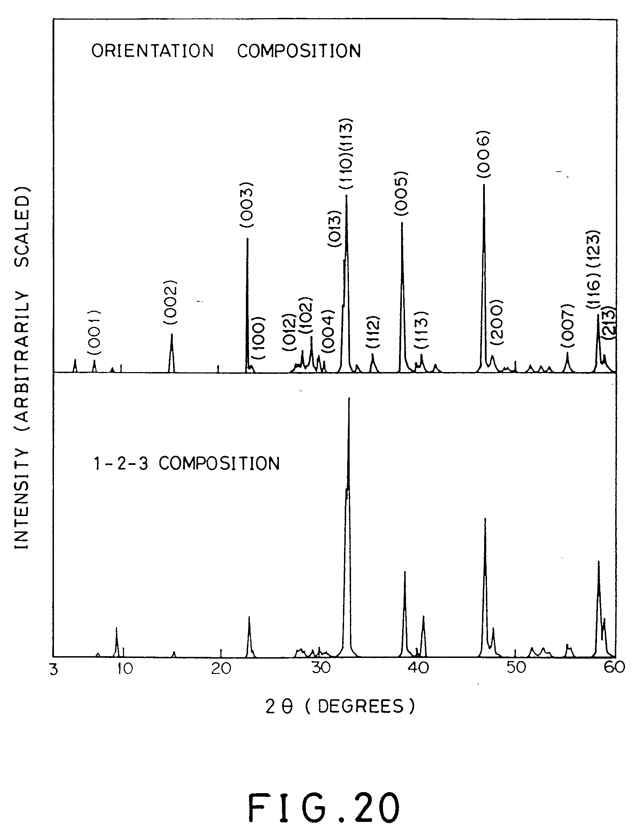

X-ray diffraction patterns for the sample with the compositions of the orientation and the 1-2-3 are shown in Fig. 20. The degree of the orientation can be estimated roughly by comparing intensities of the (00N) peaks (N is an integer) and the other peaks, for example, (006)/(110)(103). The peak ratios of R=(006)/(110)(103) were 1.06 for the sample of the orientation composition and 0.52 for that of the 1-2-3 composition.

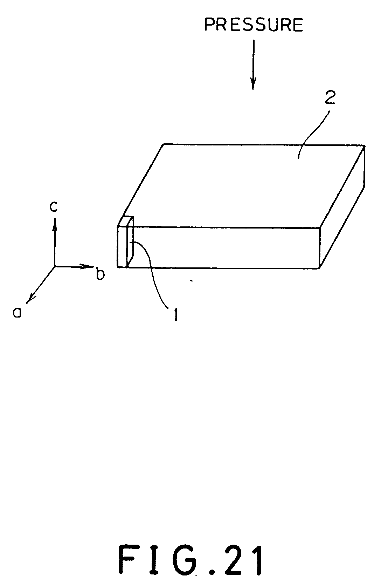

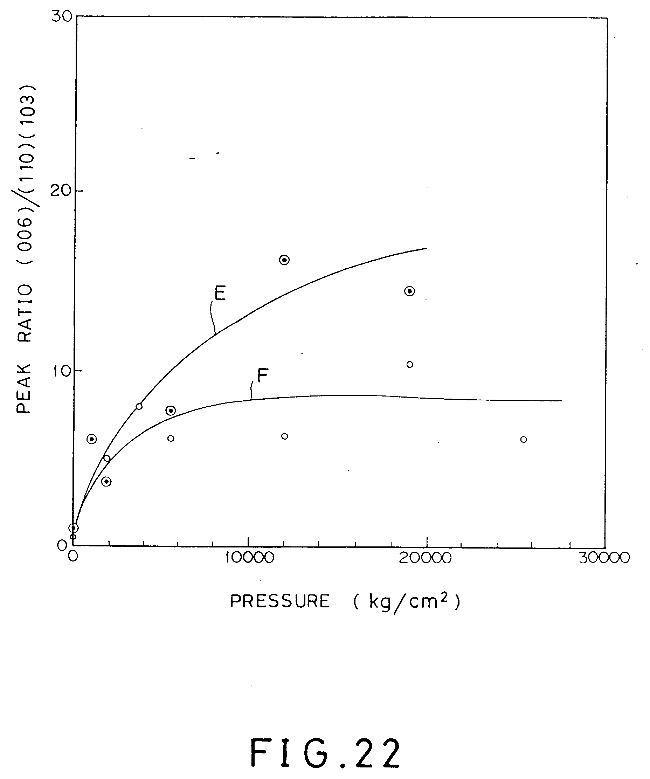

The two kinds of composition powders were pressed into pellets with various pressures and examined by X-ray diffraction. The direction of the pressure is parallel with the c-axis as shown in Fig. 21. In Fig. 22, the degrees of the orientation (estimated by (006)/(110)(103) peak ratio) are plotted against applied pressure. Curve E shows the peak ratios for the pellet samples made from the powder with the orientation composition, and curve F shows those for the sample from the powder with the 1-2-3 composition. The powder with the orientation composition shows higher orientation than that with the 1-2-3 composition.

The powder sample with the orientation composition contain a large amount of plate-like crystals which can be easily oriented by pressing. Thus, after pressing, the sample shows an excellent degree of the orientation.

As shown schematically in Fig. 21, since a unit cell 1 with a, b, and c axis (a=3.8181 Å, b=3.888 Å, c=11.688 Å) forms a plate-like crystal 2, these plate-like crystals are easily arranged by pressing to stabilize them against applied pressure.

### Example 18

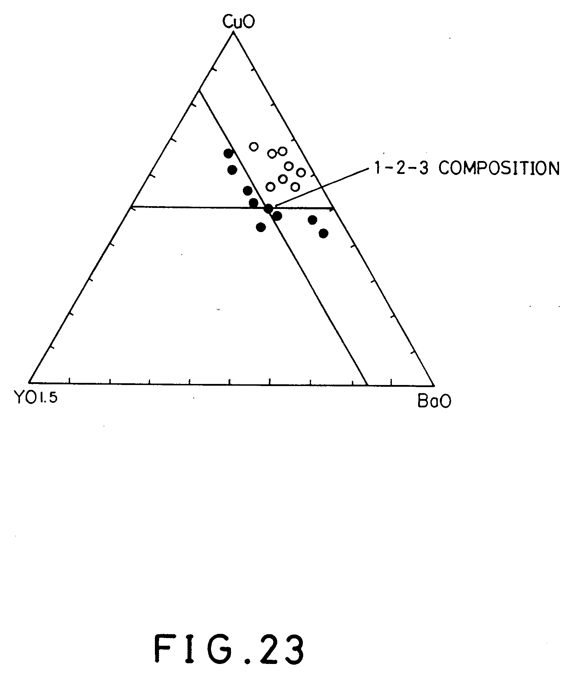

In Y-Ba-Cu-O system, compositions were changed to attain a high orientation by pressing. Mixtures of the reagents were sintered at 950°C in an oxygen atmosphere (the same condition in the example 17). Pellets were made by pressing of 19000 kg/cm². The results are shown in Fig. 23. In the ternary system graph, open circles stand for the samples which show the same order of orientation as that of the orientation composition, and closed circles for the samples which shows the same order of orientation as that of the 1-2-3 composition or less than that. The composition region of open circles (high orientation region) agrees well with that in the oriented film (see Fig. 11). The high orientation region is Y/(Y+Ba+Cu)^{<}16.6 mole % and Cu/(Y+Ba+Cu)^{>}50 mole %, which is located to Y-poor and Cu-rich side.

### Example 19

The powder samples with the 1-2-3 composition are pressed into pellets at various pressures and are resintered at 875°C for 40 hours in an oxygen atmosphere. The pellets are checked by X-ray diffraction. The peak ratios of (006)/(110)(103) in the 1-2-3 composition samples are plotted against pressures in pressing process. Curve G shows the degrees for the samples subjected to only pressing, and curve H those for the samples subjected to pressing and re-sintering at 875°C. No noticeable change in the degrees of orientation were not observed after resintering at that temperature. Although the results in the samples with the orientation composition are not shown here, but almost the same results are obtained; no decrease was observed after re-sintering at 875°C.

Electrical resistances of the re-sintered pellet samples were measured by a conventional four-probe technique. The onset temperature was 93 K, and the zero resistance temperature was 90 K.

In this example, re-sintering was carried out to ensure the mechanical strength against thermal shock in this measurement.

### Example 20

A copper alkoxide, Cu(i-OC₃H₇)₂ in isopropanol, a barium alkoxide, Ba(n-OC₄H₉)₂ in butanol and Y(n-OC₄H₉)₃ in butanol were mixed in such a ratio as give an oxide with composition, 60 mole % Cu, 30 mole % Ba and 10 mole % Y.

The resultant mixed solution was refluxed for 20 hours, and about 5 to 20 times of pure water to the total molar amount of Cu, Ba and Y was titrated into the solution with ultrasonic vibration. Then, the solution was refluxed again for about 10 hours to ensure the complete hydrolysis. The solvent in the solution was evaporated at 120-150°C for 2 or 3 days. The dried sample was sintered at 900°C for 5 hours in an oxygen atmosphere.

The sintered sample was ground into powder and examined by X-ray diffraction. As a result, c-axis oriented samples of R=(006)/(110)(103)= from 1.55 to 4 were obtained, which degrees were higher than that of the sample made from commercially available reagents (R=1.06).

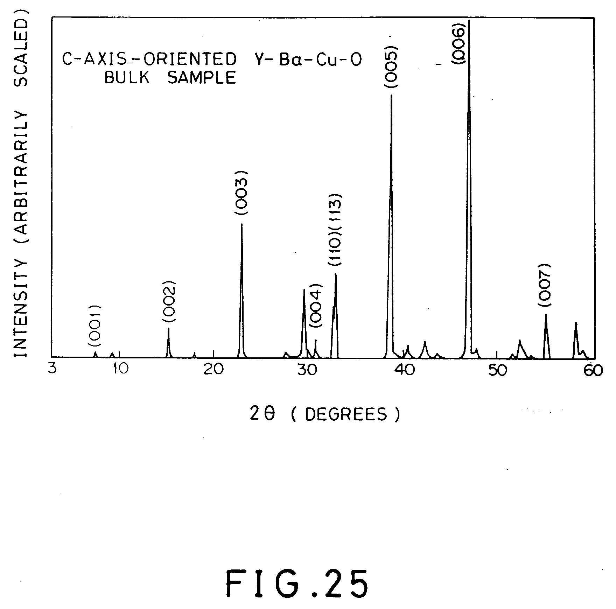

An X-ray diffraction pattern for the powder sample of R=4 obtained in the above-mentioned manner is shown in Fig. 25.

### Example 21

Reagents of Bi₂O₃, SrCO₃, CaCO₃ and CuO were mixed to make a various compositions respectively shown by open circles, closed circles and crosses in Fig. 16, and pre-sintered at 875 °C for 10 hours in a platinum boat in an oxygen atmosphere. The sintered samples were ground into powders. Then, using a pressing plate, the powders were pressed on the sample plate by a vertical pressure of 1 kg/cm² or less and X-ray diffraction patterns (CuKα) were measured.

The compositions in the region surrounded by B-C-E lines in Fig. 16 showed superconducting phases but did not show an high orientation.

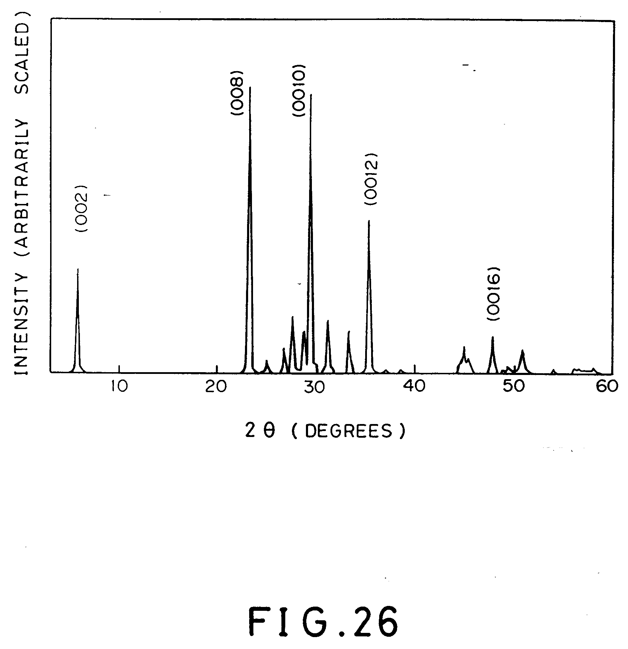

X-ray diffraction pattern for the sample of BiSrCaCu₃Oₓ is shown in Fig. 26. In this diffraction pattern, (00N) peaks show higher intensities than the other peaks even at a pressure of 1 kg/cm² or less. Thus, the composition BiSrCaCu₃Oₓ has a tendency to be highly c-axis oriented. In this diffraction pattern, the strong peak is appeared at 20=5.8°. The 5.8° peak is commonly observed in the compositions within the region surrounded by A-B-E-D lines. The samples which are shown as closed circles in Fig. 16, composition region surrounded by A-B-E-D lines, also show a superconductivity and an high orientation in making a oriented bulk sample by pressing. However, in the compositions indicated by crosses no peak was appeared at 20=5.8°, hence these compositions is not superconducting phase.

In the cases of compositions, SrO:CaO=1:3 and SrO:CaO=3:1 the obtained results were similar to that described above.

An adequate amount of propylene glycol was added to the mixed and not pre-sintered powders having various compositions shown in Fig. 16 to make pastes. Resultant pastes were coated on YSZ substrates and examined by X-ray diffraction. As shown in the example 14, the samples with compositions in the region surrounded by A-B-E-D lines showed a high orientation when films were made from them. Accordingly, it can be said that the compositions surrounded by A-B-E-D lines, compositions of Cu or Bi-rich, are suitable for making a c-axis oriented sample in both of film and bulk.

### Example 22

Reagents of Bi₂O₃_{,} SrCO₃, CaCO₃ and CuO were mixed in a mole ratio of Bi₂Sr_{1.5}Ca_{1.5}Cu₂Oₓ and presintered at 875°C for 10 hours in a platinum boat in an oxygen atmosphere. The samples were ground into powders and pressed into pellets at various pressures to examine a pressure dependency of the degree of the orientation.

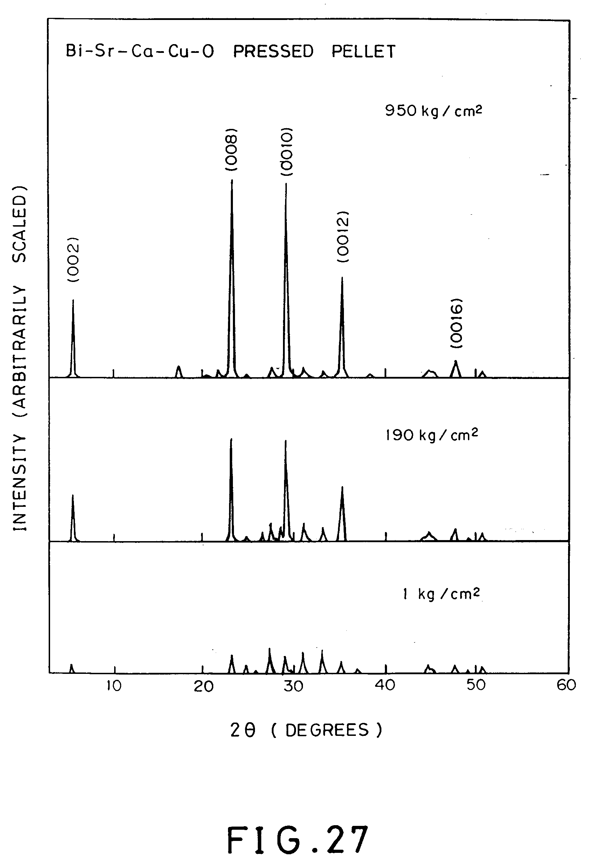

X-ray diffraction patters for these samples are shown in Fig. 27. At a pressure of 1 kg/cm² or less, no orientation was observed. At 190 kg/cm², c-axis orientation was observed, and at 950 kg/cm² the degree of the orientation was enhanced.

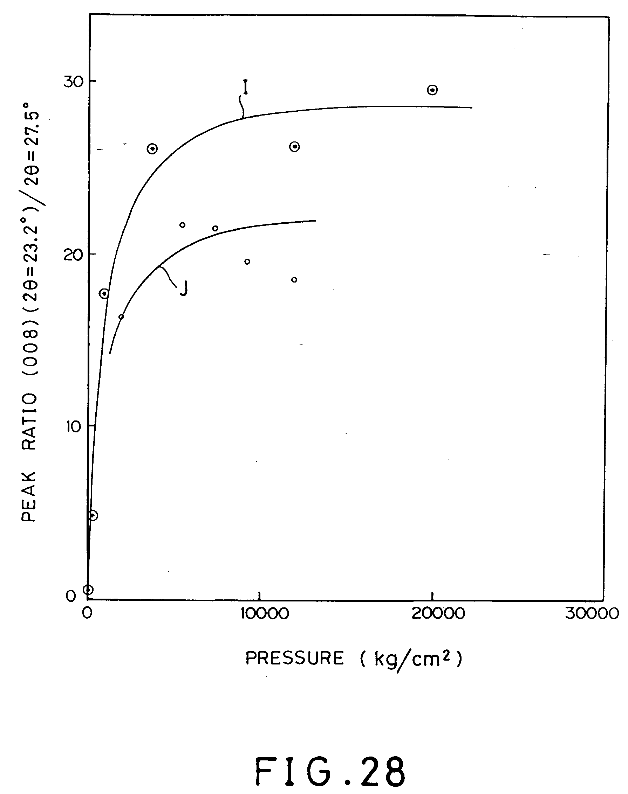

Peak ratios of (008)(2ϑ=23.2°)/2ϑ=27.5° are plotted against pressure in Fig. 28. As shown in curve I, the peak ratio increased with increasing pressure and reached a constant value 28 at 10000 kg/cm² pressure. In Fig. 28, curve J shows peak ratio of sample which is resintered at 850°C for 40 hours in air after pressing: Sintering is often necessary for using superconducting powders. From comparison with curve I, it is seen that although by re-sintering degree of orientation is slightly decreased the pressure dependency was almost same.

Electrical resistance vs temperature curves of these samples were similar to that in Fig. 18. The resistance decreased with decreasing temperature. At 110 K, a slight change of resistance observed, and the onset and zero resistance temperatures were 88 K and 83 K, respectively.

The Bi-Sr-Ca-Cu-O samples is known to have two superconducting phases of 110 K and 80 K. In this example, the sample showed a 80 K-class superconducting property.

### Example 23

Alkoxides, Bi(n-OC₄H₉)₃, Sr(n-OC₄H₉)₂, Ca(i-OC₃H₇)₂ and Cu(i-OC₃H₇)₂, were mixed in a mole ratio of Bi:Sr:Ca:Cu=2:1.5:1.5:2 in 1-butanol solvent. The solution was refluxed for 20 hours and 5 to 10 times pure water to total mole of Bi, Sr, Ca, Cu was titrated into it with ultrasonic vibration. Then, the solution was refluxed again for 10 hours to ensure the complete hydrolysis. The oxide powder sample was obtained by drying the solution.

The powder was pre-sintered at 800°C for 10 hours, and ground into powder again. The resultant powder was pressed into pellet at a pressure of 4000 kg/cm² and examined by X-ray diffraction.

The peak ratio of 2ϑ=23.2°/2ϑ=27.5 was about 30. The degree of the orientation was slightly higher than that in the example 22.

### POSSIBLE APPLICATIONS IN THE INDUSTRY

As described above, since fine oxide particles for superconductor are made in a liquid phase at a temperature less than the boiling point of the solvent in the processes according to present invention, a fine and homogeneous powder which can be sintered at a low temperature can be obtained.

By forming a buffer layer between a substrate and a superconducting film to suppress the reaction of superconductor with a substrate in sintering process, materials which ordinarily cannot be used, such as silicon, silica glass or other ceramics can be used as a substrate, and on the buffer-coated substrate, c-axis oriented YBa₂Cu₃O₇₋ₓ superconducting oxide film with good superconducting properties can be fabricated.

Hihgly c-axis oriented superconducting film and bulk products can be fabricated from the compounds with the starting compositions of Cu>50 mole % and Ln<16.6 mole % in Ln-Ae-Cu-O system.

Highly c-axis-oriented superconducting film and bulk products can be fabricated from the compounds with the starting compositions of Bi/(Bi+Ae+Cu)=5-40 mole %, Ae/(Bi+Ae+Cu)=15-70 mole %, Cu/(Bi+Ae+Cu)=24-64 mole %, and more preferably the starting compositions of Bi/(Bi+Ae+Cu)=5-40 mole %, Ae/(Bi+Ae+Cu)=15-40 mole %, Cu/(Bi+Ae+Cu)=24-64 mole %. c-axis oriented products are advantageous for superconducting film and bulk in terms of high critical current density.

Fine and homogeneous oxide particles for superconductors which can be sintered at a low temperature are prepared in a liquid phase by the sol-gel method using alkoxides as starting materials. By forming a buffer layer between a substrate and a superconducting film, good-quality and oriented superconducting film can be fabricated. Highly c-axis-oriented superconducting film and bulk products can be prepared from particular starting compositions in Ln-Ae-Cu-O and Bi-Ae-Cu-O systems. The oriented film can be produced by painting a paste of such starting compositions on a substrate followed by sintering, and the bulk can be produced by pressing the pre-sintered powder of such starting compositions.

## Claims

1. A layered superconducting oxide structure characterized by comprising:
a substrate;
a buffer layer formed on said substrate and having a low reactivity with the material of said substrate, said buffer layer being an oxide film consisting of zirconia or comprising zirconia as the main component; and
a superconducting oxide film formed on said buffer layer.
